# EUROPEAN PATENT SPECIFICATION

(11) **EP 1 884 978 B1**
(45) Date of publication and mention of the grant of the patent: **19.10.2011**
(21) Application number: 06016249.2
(22) Date of filing: 03.08.2006
(51) Int. Cl.: H01J 37/32, C23C 14/22

(54) **Process for the coating of substrates with diamond-like carbon layers**
Verfahren zur Beschichtung von Substraten mit diamantähnlichen Kohlenstoffschichten
Procédé pour la revêtement des substrats avec des couches de carbone de type diamant

(43) Date of publication of application: 06.02.2008
(73) Proprietor: Creepservice S.à.r.l., 2014 Bôle (CH)
(72) Inventor: Chizik, Anna Andreyevna, 2014 Bôle (CH); Mikhailov, Alexei Sergueievitch, 2014 Bôle (CH)
(74) Representative: Stolmár, Matthias

(56) References cited:
- WO-A-03/087425
- US-A1- 2002 007 796
- US-A1- 2005 117 257
- LEU M-S ET AL: "Diamond-like coatings prepared by the filtered cathodic arc technique for minting application" SURFACE & COATINGS TECHNOLOGY ELSEVIER SWITZERLAND, vol. 177-178, 30 January 2004 (2004-01-30), pages 566-572, XP002417791 ISSN: 0257-8972
- FUN Q H ET AL: "Diamond coating on steel with a titanium interlayer" DIAMOND AND RELATED MATERIALS, ELSEVIER SCIENCE PUBLISHERS, AMSTERDAM, NL, vol. 7, no. 2-5, February 1998 (1998-02), pages 603-606, XP004115114 ISSN: 0925-9635
- MAO D S ET AL: "ENHANCED ELECTRON FIELD EMISSION PROPERTIES OF DIAMOND-LIKE CARBON FILMS USING A TITANIUM INTERMEDIATE LAYER" JOURNAL OF PHYSICS D. APPLIED PHYSICS, IOP PUBLISHING, BRISTOL, GB, vol. 32, no. 14, 21 July 1999 (1999-07-21), pages 1570-1577, XP000919679 ISSN: 0022-3727
- SCHULTRICH B ET AL: "Neuere Entwicklungen auf dem Gebiet der Vakuumbogenbeschichtung" VAKUUM IN FORSCHUNG UND PRAXIS, vol. 10, no. 1, 1998, pages 37-46, XP002417792 Weinheim, [DE]
- LOSSY R ET AL: "FILTERED ARC DEPOSITION OF AMORPHOUS DIAMOND" APPLIED PHYSICS LETTERS, AIP, AMERICAN INSTITUTE OF PHYSICS, MELVILLE, NY, US, vol. 61, no. 2, 13 July 1992 (1992-07-13), pages 171-173, XP000280682 ISSN: 0003-6951
- MARTIN P J ET AL: "ION-BEAM-DEPOSITED FILMS PRODUCED BY FILTERED ARC EVAPORATION" THIN SOLID FILMS, ELSEVIER-SEQUOIA S.A. LAUSANNE, CH, vol. 193 / 194, no. 1 / 2, 1 December 1990 (1990-12-01), pages 77-83, XP000168982 ISSN: 0040-6090
- DING X-Z ET AL: "Structural and mechanical properties of Ti-containing diamond-like carbon films deposited by filtered cathodic vacuum arc" PREPARATION AND CHARACTERIZATION, ELSEVIER SEQUOIA, NL, vol. 408, no. 1-2, 3 April 2002 (2002-04-03), pages 183-187, XP004351360 ISSN: 0040-6090
- HENZLER M et al.: "Oberflächenphysik des Festkörpers", 1991, B. G. Teubner, Stuttgart [DE] ISBN: 3-519-03047-0 page 65,
- ZANGWILL A: "Physics at surfaces", 1988, Cambridge University Press, Cambridge [GB] ISBN: 0-521-34752-1 pages 26-27,
- FALBE J et al (editors): "Römpp Chemie Lexikon, 9th edition", 1990, Georg Thieme Verlag, Stuttgart [DE] ISBN: 3-13-734809-9 page 2006,

## Description

### Field of the invention

The present invention relates to the application of coatings in a vacuum, and particularly to an apparatus which generates a plasma of electrically conducting materials. The apparatus is used for carrying out a process which provides a substrate with a diamond-like carbon coating improving the hardness of such a substrate, cutting performance and wear resistance.

### Background of the invention

Coatings with a diamond-like carbon are known in the art.

WO 2004/083484 A1 describes the possibility of depositing a nanocrystalline diamond-like material by CVD techniques on the surface of substrates, in particular the Chemical vapour deposition techniques for obtaining these standard-like carbon layers on the surface of PCB-milling cutters.

A main problem for PCB-manufacture is a steady pressure on an increase in productivity and reduced costs with the machining of PCBs. Due to the extreme hardness of diamond, DLC coated milling cutters are also excellently suited for machining hard composite materials and extremely heat resistant high-Tg materials where the glass transition temperature (Tg) is 170° to 180°C.

US 5,435,900, US 6,663,755 and US 6,617,057 all to Vladimir I. Gorokhovsky describe the possibility of depositing coatings in a vacuum by filtered cathodic arc deposition in one single reactionchamber, wherein in a vacuum a plasma arc surrounded by a magnetic deflection system is in communication with a first plasma source and a coating chamber is used as an apparatus.

EP 1 186 683 B1 discloses the use of filtered arc carbon sources for providing a diamond-like carbon (DLC) layer on pieces used in the watch industry.

Diamond coated (DLC) milling cutters for Printed Circuit Board (PCB) are superior to ordinary carbide tools over PCB milling due of the extremely abrasive materials used and are for example disclosed in US 5,653,812, where the DLC layer is obtained by CVD techniques.

Leu M.-S., Chen, S.Y. Chang. J.J., Chao L.G., Lin W. "Diamond-like coatings prepared by the filtered cathodic arc technique for minting application" Surface and Coatings Technology, Vol. 177 - 178, (2004), pages 566 - 572 disclose a process for DLC-film deposition by a filtered vacuum cathodic arc system. Fan Q.H. et al., "Diamond coating on steel with a titamium interlayer",Diamond and Related Materials, vol.7, no. 2-5 (1998), pages 603 -606, reports a high-speed sted (HSS) substrate coaled with a titanium interlayer and a diamand top coating.

### Objects of the invention

The trend in PCB milling cutters and drills to deeper drilled holes makes it increasingly difficult to obtain deeper holes (total length of drilling) as well as a good quality of holes. As a result the geometry of the substrate and the coating must be exactly matched to the application. Standard tools, e.g. the twister of rough coatings mainly used, can not handle these loads and specification and are often unable to convert the machine output into cutting performance.

Therefore, the problem underlying the invention was to provide a further and a better process for coating substrates of drilling and cutting devices with diamond-like carbon layers which would enable longer life time of tools coated therewith and better quality holes.

This problem has been solved by a process for coating a substrate of a drilling and/or cutting device with a wear resistant layer on the basis of carbon comprising the steps of
i) providing a substrate of a drilling and/or cutting device containing a material which has an affinity for carbon
ii) ion-bombardment of a surface of the substrate by noble gas ions
iii) deposition of a metal layer, on said surface by a filtered ion beam containing one or more metal ions selected from the group of Ti, W, Cr and mixtures thereof, whereas the metal layer is deposited on the substrate at "bias" voltage applied to the substrate between 0 V to 100 V
iv) ion-bombarding of the coated surface by noble gas ions v) deposition of a carbon layer on the surface by a pulsed filtered ion beam containing essentially carbon ions.

The process according to the invention provides a DLC coating with a good adhesion on a substrate at low temperature, which is very hard (> 40 GPa) which is self-lubricant and relatively thick and is deposited at low temperatures.

The unexpected effects and hardness as well as the durability of the DLC layers may also be ascribed to the provision of an interface layer of titanium which provides a better adhesion of DLC on the surface at relatively low temperature (lower than 200°C). The partial overlap of the carbon and titanium layer due to the ion implantation technique used in the process according to the invention provides additional strength and better adhesion of the two coatings on the surface of the substrate.

A sharpening of the edges of the substrate, e.g. of cutting edges as drills may be obtained, by additional ion bombardment for example with Ar ions prior to step iii). Steps iv) and v) may be repeated several times to obtain thicker DLC layers on the surface, i.e. thicker than 1µm (micron)

An optional cooling step after the deposition of the metal layer is carried out, whereby the substrate coated with the metal, for example titanium layer is cooled down to less than 100°C, preferably less than 70°C. The cooling provides an even better adhesion of DLC on the metal surface. The metal may be one or more of Ti, W, Cr and mixtures thereof. For ease of lecture, in the following titanium is used but stands also as pars pro toto for the other metals and mixtures mentioned above.

The deposition of the metal is preferably carried out at temperatures of more than 200°C to obtain a good adhesion. The metal "interface" layer is deposited on the substrate at a "bias" (voltage applied to the substrate) between 0-10OV. However, for an efficient adhesion of the deposited carbon a temperature of less than 70°C is required. The time for cooling down the substrate can be reduced to less than 10 minutes by an in-line arrangement. In-line arrangement in the context of the present invention means that each process step is carried out in a specific area/place, for example in a reaction chamber, which are located at different places, but arranged along a line one after the other.

The ion bombarding by noble gases, in particular Ar, of the coated surface eliminates impurities which may affect the adhesion of the carbon layer on the titanium layer and may be carried out several times, especially if several carbon deposition steps are to be carried out.

Moreover, at the optimum conditions, namely, bias voltage, current, type of ions and substrate, the ion bombardment increase the sharpness of the cuttings edges of tools and may be as explained in the foregoing additionally carried out prior to step iii).

Preferably, the substrate is a metallic substrate, wherein the metal of the metallic substrate is selected from the group of one or more of iron, chrome, vanadium, tungsten, molybdenum, nickel, niobium, tantalum and its alloys. Thereby any known tool, as cutters, drills etc. can be used as a substrate to harden and sharpen its surface or cutting edges.

In further embodiments of the invention, the substrate is a ceramic substrate, thus giving access to specific ceramic based substrates and tools. In this case the substrate contains oxides, nitrides, carbides, silicides, tantanides of one or more of iron, chrome, vanadium, tungsten, molybdenum, nickel, niobium, tantalum.

The cleaning step is preferably carried by ion beam sputtering, preferably in vacuum. It is understood that equivalent measures can be applied as well.

The deposition of the metal prior to the carbon deposition is carried out by a filtered ion beam containing essentially metal ions. After the metal deposition, ion bombarding is carried out with noble gas ions, preferably by argon ions.

The final deposition of carbon is carried out by a pulsed filtered ion beam containing essentially carbon ions, thus implanting only pure carbon. The ion beam does not contain C-H compounds as in other techniques therefore smooth C-H compounds and implantation products are not formed as in prior art techniques. Preferably, the coating is carried out at a temperature of less than 100°C, more preferred less than 70°C.

The thickness of the carbon implantation zone is in the range of between 50 to 100 nanometer which has preferably a constant gradient in carbon atom concentration from 0 to 100%. It is understood that the carbon implantation can reach deeper in the substrates than the metal, for example titanium implantation and in the titanium layer, consequently both implantation zones have a certain overlap.

The total pure carbon DLC layer on the surface of the substrate has thickness of 20 to more than 1000 nanometer, namely 1500 nanometer, thus enabling a variety of applications.

The problem underlying the invention is also solved by a substrate having metal, especially a titanium layer on a surface of the substrate and a layer of diamond-like carbon arranged on said metal layer, wherein the carbon layer and the metal layer are partially overlapping and the carbon layer has a gradient in carbon atom concentration from 0 to 100%.

The deposited thickness of the metal layer is preferably 150 to 250 nanometer.

The thickness of the diamond-like carbon layer is 20 to 1500 nanometres.

In preferred embodiments, the substrate is a drill, mill cutter, blade, etc.

The problem underlying the invention is further solved in an apparatus for the coating of substrates with diamond-like layers comprising a plurality of devices including
i) a metal filtered arc ion source
ii) a carbon ion filtered arc source
iii) an ion gun
iv) an infrared heating device
v) a cooling chamber.

The single devices are arranged in-line, each in a separate reaction chamber.

The in-line arrangement of the devices each in a single chamber allows inter alia a significant reduction of the time to cool down the substrate once coated with the metal.

For example, with respect to a one-chamber apparatus as used in prior art for similar techniques, the time for cooling down the metal/titanium coated substrate where the coating has to be carried out at more than 200°C is about one to two hours. In the in-line system, where each device is arranged in a single chamber separated from the other chambers and linked by a moving device for the substrate to be coated being transported from one chamber to the next one, the time for cooling down the titanium coated substrate is about ten minutes.

This is an enormous time benefit for carrying out the process according to the invention.

Further, the in-line arrangement allows the use of a plurality of substrates, that is according to the sample holder used several hundreds or even thousands of smaller substrates to be coated at the same time, which increases dramatically the output of the process according to the invention.

The apparatus allows the use of several sample holders at the same time, which are preferably in the form of cassettes where the substrates, for example drills, cutting edges etc., are coated. In each chamber of the apparatus, a sample holder is actually treated at the specific step of the process according to the invention.

This advantage increases the output of the process by a factor of ca. 500% with respect to a single reaction chamber according to the prior art where each process step has to be performed.

The metal source, in particular Ti, is a filtered arc ion source, in order to assure homogeneous adhesive layer when the cathode is made from the corresponding metals or alloys thereof.

The carbon source is a pulsed, filtered or non filtered arc source, or laser ablation source to sputter graphite target, in order to create diamond like carbon coatings on substrates

The ion gun is a low energy, preferably lower than 300V ion gun of the Kaufman-type.

The substrate to be coated is preferably a metal containing substrate.

The substrate is according to the geometry preferably arranged parallel to the ion flux from the ion source, specifically in the case of cylindrical, elongated substrates like drills to be coated on a cutting edge.

Preferably, these cylindrical substrates are for example drills to be coated and the rotational axis is parallel to the incoming ion flux so that only the edges of the cutting tools are coated, which offers an unprecedented advantage concerning the decrease of the amount of DLC to be used in order to obtain efficient drilling and cutting tools. It is understood that other substrates which are not necessarily in the form of cylindrical substrates can also be used in the process according to the invention, for example blades, forks, knives etc.

The metal of the substrate is selected from one or more of the following: steel, iron, vanadium, tungsten, chrome, nickel, niobium, tantalum or their metal oxides, carbides, nitrides, silicides.

A key feature of the apparatus is that if cylindrical or conical substrates, like for example drills, are to be coated by the combination of ion implantation, ion mixing and of negatively biased surfaces in this system very hard DLC-layers for PCB milling application are provided.

The process is described in detail with respect to the coating of drills:

The fixture of the substrate in a specific embodiment a plurality of drills includes a portion of the drills to be coated, an electric insulated spacer and electrically grounded shield. The fixture in the form of a cassette or any other suitable holder contains a plurality of single drills to be coated, usually several hundreds. The holder is arranged in a double rotation sample holder (planetary system). A loaded fixture is placed into a plasma deposition vacuum chamber and air in said chamber is evacuated. Gas is added to the vacuum chamber ion beam gun is ignited, causing the surface of the drills to be sputter-etched to remove residual contaminants and surface oxides and to activate the surface, and moreover, at optimum conditions to make the cutting edges sharper. Afterwards a titanium containing material layer, preferably pure titanium, is deposited by arc plasma deposition. This titanium containing material layer may be used an adhesion layer for subsequent deposition of DLC like carbon. The samples (i.e. the drills) are along their length fixed in parallel to the ion flux direction coming from the arc source where the cutting edges are directly exposed to the ion flux. This geometry preferably allows the increase of the input of the deposition of the machine for drill cutting, since a higher quantity of drill can be loaded in one charger of the machine. This geometry is preferred because the micro-drills have a conical shape where the functional cutting edge is the most important part to be coated.

The invention is explained in still further details with reference to the figures. It is understood that the explanation in the figure are by no means a limitation of the scope of the invention.
- Fig. 1: shows a schema of an apparatus with different chambers
- Fig. 2: shows a detailed side view of a drill to be coated in the chamber with an arc ion source
- Fig. 3a: shows a detailed sectional view of an apparatus according to the prior art.
- Fig.3b: shows a front view of an apparatus according to the prior art.
- Fig. 3c: shows a side view of an apparatus according to the prior art.

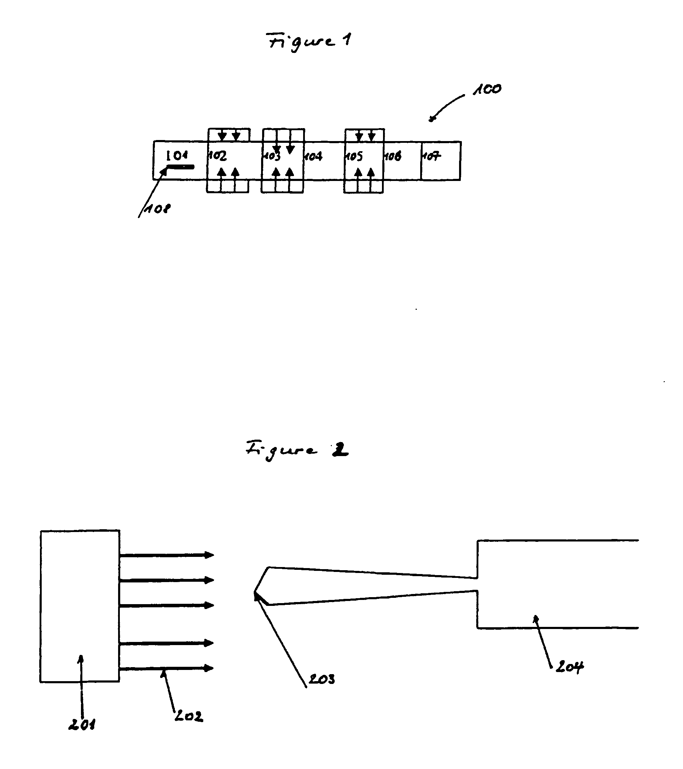

Fig. 1 shows an apparatus (100) which has several reaction chambers 101, 102, 103, 104, 105, 106 and 107.

A substrate 108 or a plurality of substrates 108, for example drills, is placed on a sample holder in chamber 101. The sample holder is arranged in that way that it is in the position to move from chamber 101 to chamber 107 and the drills are fixed on the sample holder in such a way that they are perpendicular to the direction of the movement. Chamber 101 is termed as "loading chamber".

Thus, in chamber 101 the charging of the sample holder 108 with the drills which are not represented in Fig. 1 is carried out.

After being charged with a plurality of samples (identical or different ones), the sample holder 108 moves to the ion surface polishing chamber 102 which is carried out as indicated by the arrows, a sputter cleaning is applied to further obtain the heating at a temperature of 250°C by means of argon ions.

After the ion surface polishing, sputter cleaning and heating, the sample holder 108 moves to the first metal deposition chamber 103.

In the metal deposition chamber 103 the deposition of a metal layer, for example titanium (adhesion layer) from a non represented filtered arc source and beam mixing by ion gun is carried out.

The arc ion source is represented by the arrows which represent schematically the ion beam.

The deposition can occur on both sides of the substrate. After being coated with a first metal layer, the sample holder 108 moves to a cooling chamber 104 where the sample holder 108 and the drills or substrates to be coated are cooled down to around 100°C.

After passing the cooling chamber 104 the sample holder moves further to chamber 105 where the carbon deposition/ion beam mixing takes place. The arrows show also a schematic representation of the carbon ion beams.

After being coated with carbon, the sample holder 108 moves further to chambers 106 and 107 where the samples can be recovered.

As already explained in the foregoing, one of the main advantages of the apparatus is that during the process according to the invention, in each chamber one cassette containing a plurality of substrates to be coated is present. This allows for example according to the specific embodiment of Fig. 1 the parallel processing of seven substrate holders at the same time, i.e. several hundreds of different or identical substrate edges can be continuously coated.

Fig. 2 shows in detail a sectional view of a sample 204 which is a drill made for example from an iron alloy which is based in front of an arc ion source 201.

The ion beams coming from the source of deposition are indicated as arrows 202. The ions in the ion beam 202 will arrive especially at the section 203, i.e. the front part of the drills to be coated and will provide a thicker coating on the front part of the drill with respect to the other non perpendicular arranged parts of the drills.

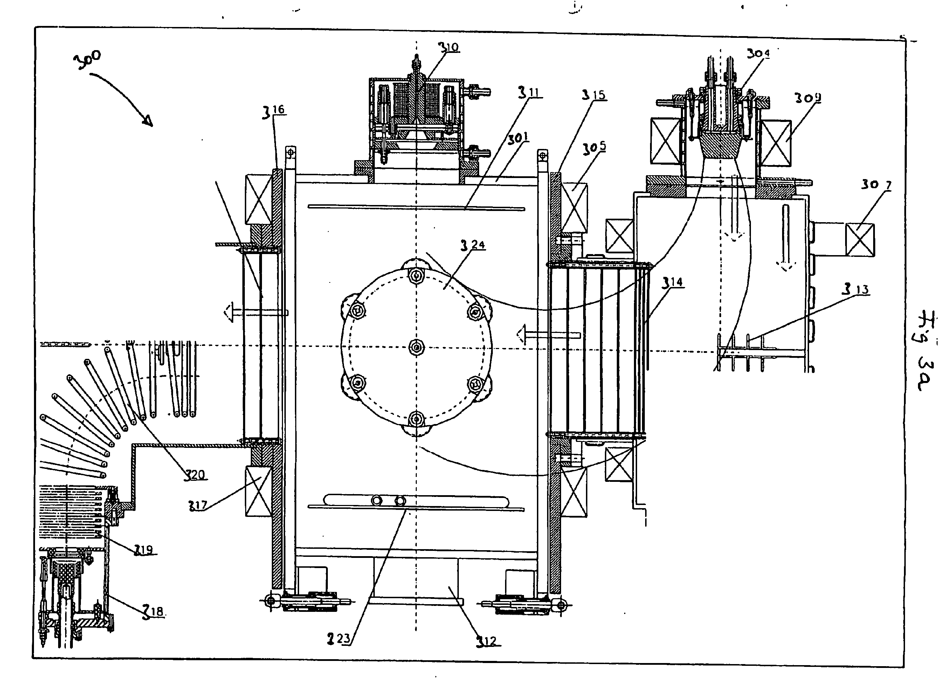

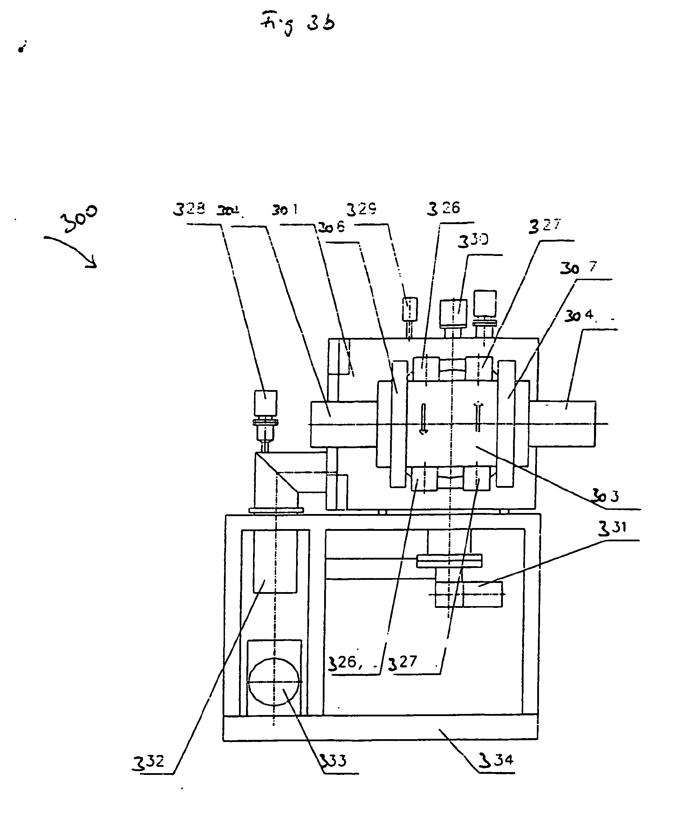

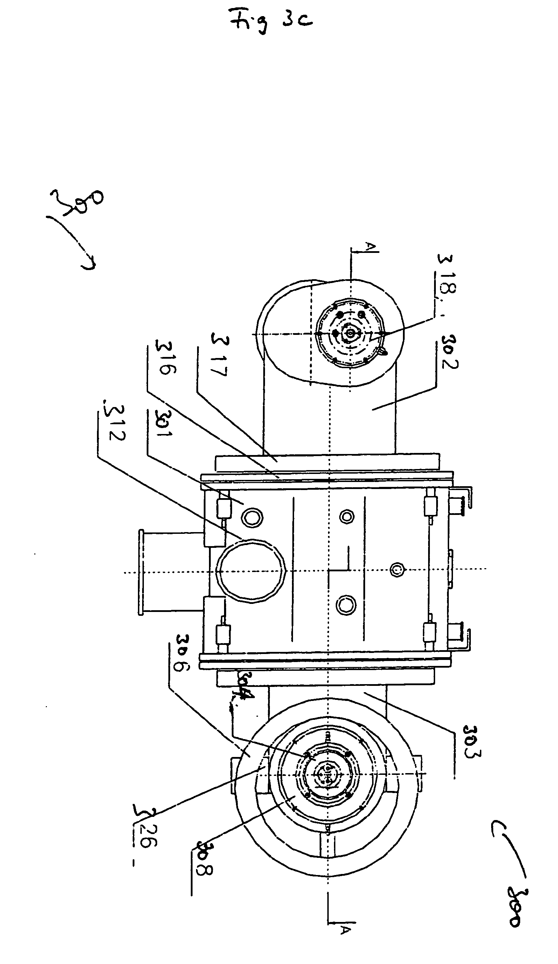

Fig. 3a to 3c show a detailed sectional view of an apparatus 300 according to the prior art as a one chamber apparatus.

It is possible to use this apparatus for the purpose of the process according to the invention and gives similar results, however, as explained in the foregoing, the output is reduced compared to the in-line system according to the invention.

The apparatus 300 consists of a vacuum chamber 301 with a pulsed carbon plasma system 302 and a metal plasma system 303 as described in the foregoing. The metal arc source 304 and a focusing solenoid 305 are also arranged at the chamber 301. Further solenoids 306, 307, 308 and 309 are used for the stabilization of the system. A low energy ion gun 310 is arranged on one side of the vacuum chamber 301 as well, and shields 311, 330 and a vacuum pump system 312. Further systems 313 and 314 are arranged for the trapping of macroparticles which may result from the process of the invention. Vacuum doors 315 and 316 provide access to the chamber 301. A further focusing seolenoid 317 is also arranged in the vicinity of the vacuum door 316. A carbon plasma arc source 318 with an additional anode 319 for the pulsed arc carbon source provide the device for the carbon coating of a substrate together with a magnetic filter system 320 for the source 318. An infrared heater 323 is arranged oppoosite to the low energy ion gun 310. The sample holder 324 has a so-called double rotated planetary system. Furtheer solenoids 326 and 327 for the plasma deviation are also provided together with vacuum meters 328 and 329. The rotation is controlled by the device 331. A turbopump 332 a further pump 333 and a support 334 are further details of the apparatus 300.

### Example 1

Drills containing a basic alloy of tungsten WC (tungsten carbide) were coated with the titanium/DLC layer according to the process of the present invention.

After having been coated, the drills were removed from the apparatus and subjected to a drilling test.

The drilling tests were carried out by drilling holes for a diameter of 0.1 um and 0.2 um drills at a rotation speed of 300.000 turns per minute and 220.000 turns per minute respectively.

The average increase in the 0.2 drills of the length of the drilling is in the factor of 8.

The average increase in the length of a drilling for a 0.1 drill is in the factor of 10. The quality of the whole was measured by means of electron microscopy in accordance with the standard given on the two union web page http://www.uniontool.co.jp/English/tech_02.html

## Claims

1. Process for coating a substrate of a drilling and/or cutting device with a wear resistant layer on the basis of carbon comprising the steps of
i) providing a substrate of a drilling and/or cutting device containing a material which has an affinity for carbon
ii) ion bombardment of a surface of the substrate by noble gas ions
iii) deposition of a metal layer on said surface by a filtered ion beam containing one or more metal ions selected from the group of Ti, W, Cr and mixtures thereof, whereas the metal layer is deposited on the substrate at a "bias" voltage applied to the substrate between 0 V to 100 V
iv) ion-bombarding the coated surface by noble gas ions
v) deposition of a carbon layer on the surface by a pulsed filtered ion beam containing essentially carbon ions.

2. Process according to claim 1, **characterized in that** prior to step iv) the substrate is cooled down to < 100°C.

3. Process according to claim 2, **characterized in that** the substrate is a metallic substrate.

4. Process according to claim 3, **characterized in that** the metal of the metallic substrate is selected from the group of one or more of iron, chromium, vanadium, tungsten, molybdenum, nickel, niobium, tantalum.

5. Process according to claim 2, **characterized in that** the substrate is a ceramic substrate.

6. Process according to claim 5, **characterized in that** the substrate contains oxides, nitrides, carbides, silicides of one or more of iron, chromium, vanadium, tungsten, molybdenum, nickel, niobium, tantalum.

7. Process according to one of the preceding claims, **characterized in that** a cleaning step is carried by ion beam sputtering and polishing.

8. Process according to claim 1, **characterized in that** the noble gas is argon.

9. Process according to claim 1, **characterized in that** the thickness of the carbon implantation zone is in the range of between 50 to 100 nanometres.

10. Process according to claim 9, **characterized in that** the carbon implantation zone has a gradient in carbon atom concentration from 0 to 100%.

11. Process according to claim 10, **characterized in that** a diamond-like carbon (DLC) layer on the surface of the substrate has thickness of 20 to 1500 nanometers.

12. A drilling and/or cutting device having a titanium layer on a surface of a substrate and a layer of diamond-like carbon (DLC) arranged on said titanium layer, wherein the carbon layer and the titanium layer are partially overlapping and the carbon layer has a gradient in carbon atom concentration from 0 to 100%manufactured by the process according to any of claims 1 to 11.

13. The drilling and/or cutting device according to claim 12, **characterized in that** the thickness of the titanium layer is 150 to 250 nanometres.

14. The drilling and/or cutting device according to claim 13, **characterized in that** the thickness of the diamond-like carbon (DLC) layer is 20 to 1500 nanometres.

15. The drilling and/or cutting device according to one of claims 12 to 14, **characterized in that** the substrate is a drill.

## Patentansprüche

1. Verfahren zum Beschichten eines Substrats einer Bohr- und/oder Schneidevorrichtung mit einer verschleißfesten Schicht auf der Basis von Kohlenszoff, umfassend die Schritte des
i) Bereitstellens eines Substrats einer Bor- und/oder Schneidevorrichtung, die ein Material ulfasst, das eine Affinität für Kohlenstoff aufweist
ii) Ionenbeschuß einer Oberfläche des Substrats durch Edelgasionen
iii)Abscheiden einer Metallschicht auf der Oberfläche durch einen gefilterten Ionenstrahl, der ein oder mehrere Metallionen, ausgewählt aus der Gruppe aus Ti, W, Cr und Mischungen davon enthält, während die Metallschicht auf dem Substrat bei einer an dem Substrat angelegten "Vorspannung" von 0 V bis 100 V abgeschieden wird
iv) Ionenbeschuss der beschichteten Oberfläche durch Edelgasionen
v) Abscheiden einer Kohlenstoffschicht auf der Oberfläche durch einen gepulsten gefilterten Ionenstrahl, der im Wesentlichen Kohlenstoffionen enthält.

2. Verfahren nach Anspruch 1, **dadurch gekennzeichnet, dass** vor Schritt iv) das Substrat auf < 100 °C abgekühlt wird.

3. Verfahren nach Anspruch 2, **dadurch gekennzeichnet, dass** das Substrat ein metallisches Substrat ist.

4. Verfahren nach Anspruch 3, dadurch gekenntzeichnet, dass das Metall des metallischen Substrats ausgewählt ist aus der Gruppe aus einem oder mehreren der Metalle Eisen, Chrom, Vanadium, Wolfram, Molybdän, Nickel, Niob, Tantal.

5. Verfahren nach Anspruch 2, **dadurch gekennzeichnet, dass** das Substrat ein keramisches Substrat ist.

6. Verfahren nach Anspruch 5, **dadurch gekennzeichnet, dass** das Substrat Oxide, Nitride, Carbide, Silizide von einem oder mehreren der Metalle Eisen, Chrom, Vanadium, Wolfram, Molybdän, Nickel, Niob, Tantal enthält.

7. Verfahren nach einem der vorhergehenden Ansprüche, **dadurch gekennzeichnet, dass** durch Ionenstrahlsputtern und Polieren ein Reinigungsschritt ausgeführt wird.

8. Verfahren nach Anspruch 1, **dadurch gekennzeichnet, dass** das Edelgas Argon ist.

9. Verfahren nach Anspruch 1, **dadurch gekennzeichnet, dass** die Dicke der Kohlenstoffimplantationszone im Bereich zwischen 50 und 100 Nanometern liegt.

10. Verfahren nach Anspruch 9, **dadurch gekennzeichnet, dass** die Kohlengtoffimplantationszone einen Gradienten in der Kohlenstoffkonzentration von 0 bis 100 % aufweist.

11. Verfahren nach Anspruch 10, **dadurch gekennzeichnet, dass** eine diamantartige Kohlenstoff-(DLC-)schicht auf der Oberfläche des Substrats eine Dicke von 20 bis 1500 Nanometern aufweist.

12. Bohr- und/oder Schneidevorrichtung mit einer Titanschicht auf einer Oberfläche eines substrats und einer Schicht aus diamantartigem Kohlenstoff (DLC), die auf der Titanschicht angeordnet ist, wobei die Kohlenstoffschicht und die Titanschicht teilweise überlappen und die Kohlenstoffschicht einen Gradienten in der Kohlenstoffatomkonzentration von 0 bis 100 % aufweist, hergestellt durch das Verfahren nach einem der Ansprüche 1 bis 11.

13. Bohr- und/oder Schneidevorrichtung nach Anspruch 12, **dadurch gekennzeichnet, dass** die Dicke der Titanschicht 150 bis 250 Nanometer beträgt.

14. Bohr- und/oder Schneidevorrichtung nach Anspruch 13, **dadurch gekennzeichnet, dass** die Dicke der diamantartigen Kohlenstoff-(DLC-)Schicht 20 bis 1500 Nanometer beträgt.

15. Bohr- und/oder Schneidevorrichtung nach einem der Ansprüche 12 bis 14, **dadurch gekennzeichnet, dass** das Substrat ein Bohrer ist.

## Revendications

1. Procédé d'enduction d'un substrat d'un dispositif de perçage et/ou de coupe avec une couche résistante à l'usure à base de carbone, comprenant les étapes de
i) fourniture d'un substrat d'un dispositif de perçage et/ou de coupe contenant un matériau qui possède une affinité pour le carbone
ii) bombardement ionique d'une surface du substrat par des ions de gaz noble
iii)dépôt d'une couche métallique sur ladite surface par un faisceau d'ions filtré contenant un ou plusieurs ions métalliques sélectionnés parmi le groupe constitué de Ti, W, Cr et des mélanges de ceux-ci, tandis que la couche métallique est déposée sur le substrat à une tension de « polarisation » appliquée au substrat comprise entre 0 V et 100 V
iv) bombardement ionique de la surface enduite par des ions de gaz noble
v) dépôt d'une couche de carbone sur la surface par un faisceau d'ions filtré pulsé contenant essentiellement des ions de carbone.

2. Procédé selon la revendication 1, **caractérisé en ce qu'**avant l'étape iv), le substrat est refroidi à une température inférieure à 100°C.

3. Procédé selon la revendication 2, **caractérisé en ce que** le substrat est un substrat métallique.

4. Procédé selon la revendication 3, **caractérisé en ce que** le métal du substrat métallique est sélectionné parmi le groupe constitué d'un ou plusieurs métaux parmi le fer, le chrome, le vanadium, le tungstène, le molybdène, le nickel, le niobium, le tantale.

5. Procédé selon la revendication 2, **caractérisé en ce que** le substrat est un substrat céramique.

6. Procédé selon la revendication 5, **caractérisé en ce que** le substrat contient des oxydes, nitrures, carbures, siliciures d'un ou plusieurs métaux parmi le fer, le chrome, le vanadium, le tungstène, le molybdène, le nickel, le niobium, le tantale.

7. Procédé selon l'une des revendications précédentes, **caractérisé en ce qu'**une étape de nettoyage est effectuée par gravure ionique et polissage.

8. Procédé selon la revendication 1, **caractérisé en ce que** le gaz noble est l'argon.

9. Procédé selon la revendication 1, **caractérisé en ce que** l'épaisseur de la zone d'implantation de carbone est dans la plage comprise entre 50 et 100 nanomètres.

10. Procédé selon la revendication 9, **caractérisé en ce que** la zone d'implantation de carbone possède un gradient de concentration en atome de carbone allant de 0 à 100 %.

11. Procédé selon la revendication 10, **caractérisé en ce qu'**une couche de carbone sous forme de diamant amorphe (DLC) à la surface du substrat possède une épaisseur de 20 à 1500 nanomètres.

12. Dispositif de perçage et/ou de coupe ayant une couche de titane sur une surface d'un substrat et une couche de carbone sous forme de diamant amorphe (DLC) agencée sur ladite couche de titane, dans lequel la couche de carbone et la couche de titane se chevauchent partiellement et la couche de carbone possède un gradient de concentration en atome de carbone allant de 0 à 100 % fabriqué par le procédé selon l'une quelconque des revendications 1 à 11.

13. Dispositif de perçage et/ou de coupe selon la revendication 12, **caractérisé en ce que** l'épaisseur de la couche de titane est de 150 à 250 nanomètres.

14. Dispositif de perçage et/ou de coupe selon la revendication 13, **caractérisé en ce que** l'épaisseur de la couche de carbone sous forme de diamant amorphe (DLC) est de 20 à 1500 nanomètres.

15. Dispositif de perçage et/ou de coupe selon l'une des revendications 12 à 14, **caractérisé en ce que** le substrat est un foret.
